# EUROPEAN PATENT APPLICATION

(11) **EP 4 283 024 A1**
(43) Date of publication of application: **29.11.2023**
(21) Application number: 21921250.3
(22) Date of filing: 06.12.2021
(51) Int. Cl.: C30B 25/20, H01L 21/205, C30B 29/06, C23C 16/24

(54) **METHOD FOR MANUFACTURING EPITAXIAL WAFER**

(30) Priority: 25.01.2021 JP 2021009549
(71) Applicant: Shin-Etsu Handotai Co., Ltd., Tokyo 100-0004 (JP)
(72) Inventor: SUZUKI, Katsuyoshi, Annaka-shi, Gunma 379-0196 (JP)
(74) Representative: Mooser, Sebastian Thomas
(86) International application number: PCT/JP2021/044763
(87) International publication number: WO 2022/158148

(57) **Abstract**

The present invention is a method for producing an epitaxial wafer forming a single crystal silicon layer on a single crystal silicon wafer, comprising, a step of removing native oxide film on surface of the single crystal silicon wafer with hydrofluoric acid, a step of forming an oxygen atomic layer on the surface of the single crystal silicon wafer from which the native oxide film has been removed, a step of epitaxially growing the single crystal silicon layer on the surface of the single crystal silicon wafer on which the oxygen atomic layer is formed, wherein the plane concentration of oxygen in the oxygen atomic layer is 1×10¹⁵ atoms/cm² or less. As a result, a method for producing an epitaxial wafer, that an oxygen atomic layer can be stably and simply introduced into an epitaxial layer, and having a good-quality single crystal silicon epitaxial layer is provided.

## Description

### TECHNICAL FIELD

The present invention relates to a method for producing an epitaxial wafer.

### BACKGROUND ART

Silicon substrates on which semiconductor devices such as solid-state imaging devices and other transistors are formed are required to have a function of gettering elements that disturb device characteristics, such as heavy metals. As gettering, various methods have been proposed and put into practical use, such as a polycrystalline silicon (Poly-Si) layer provided on the back surface of the silicon substrate, forming a layer damaged by blasting, a silicon substrate with a high concentration of boron, or forming precipitates. In the gettering by oxygen precipitation, a metal with a high ionization tendency (low electronegativity) is gettered by oxygen with a high electronegativity.

Also, so-called proximity gettering, in which a gettering layer is formed in the vicinity of the active region of the device, has been proposed. For example, there is a substrate in which silicon is epitaxially grown on a substrate into which carbon ions are implanted. In gettering, the element must diffuse to the gettering site (the energy of the entire system is lowered by bonding or clustering at the site rather than when the metal exists as a single element). Considering that the diffusion coefficient of metal elements contained in silicon differs depending on the element, and that the metal cannot diffuse to the gettering site due to the recent decrease in process temperature, a method of proximity gettering has been proposed.

If oxygen can be used for proximity gettering, a silicon substrate with a very powerful gettering layer can be expected. In particular, if the epitaxial wafer has an oxygen atomic layer in the middle of the epitaxial layer, metal impurities can be gettered reliably even in recent low-temperature processes.

The gettering of metal impurities has been described above. For example, as an effect of oxygen, it is known that forming a CVD oxide film on the back surface prevents auto-doping during epitaxial growth.

Reference is made to the prior art. Patent Document 1 describes a method of forming a thin layer of oxygen on silicon and then growing silicon as a structure. This method is a technique based on ALD ("Atomic Layer Deposition"). ALD is a method of adsorbing a molecule containing a target atom and then dissociating/desorbing unnecessary atoms (molecules) in the molecule, and it utilizes surface bonding, is highly accurate, and has excellent reaction controllability, and is widely used.

Patent Document 2 describes a method of forming a native oxide film on a silicon clean surface formed by vacuum heating or the like and then adsorbing and depositing an oxide film or other substance.

Patent Documents 3 and 4 show that introduction of a plurality of oxygen atomic layers into a silicon substrate can improve device characteristics (mobility).

Patent document 5 shows a method of forming an epitaxial layer using SiH₄ gas on an atomic layer having a thickness of 5 nm or less. Also, a method of forming an oxygen atomic layer with oxygen gas is shown as the atomic layer.

Patent Documents 6 and 7 describe a method of epitaxially growing single crystal silicon after forming an oxide film by bringing the surface of a semiconductor substrate into contact with an oxidizing gas or an oxidizing solution.

Patent Document 6 describes a method in which a silicon deposition gas is flowed after an oxidizing gas is flowed.

Non-Patent Document 1 discloses a method of forming an amorphous silicon film by low-pressure CVD after removing a native oxide film by HF, oxidizing it in the atmosphere, and then forming single crystal silicon by heat treatment for crystallization.

### CITATION LIST

### PATENT LITERATURE

Patent Document 1: JP 2014-165494 A
Patent Document 2: JP H05-243266 A
Patent Document 3: Unite States Patent No. 7,153,763 Specification
Patent Document 4: Unite States Patent No. 7,265,002 Specification
Patent Document 5: JP 2019-004050 A
Patent Document 6: JP 2008-263025 A
Patent Document 7: JP 2009-016637 A

### NON PATENT LITERATURE

Non Patent Document 1: I. Mizushima et al., Jpn. J. Appl. Phys. 39 (2000) 2147.

### SUMMARY OF INVENTION

### TECHNICAL PROBLEM

As described above, the method of gettering metal impurities by forming a layer of oxygen in the wafer has been conventionally used. However, in the conventional technique, although a thin layer of oxygen can be obtained with high accuracy, there are problems in that the structure of the apparatus is complicated and the number of steps is increased.

For example, in the technique described in Patent Document 1, since ALD cannot epitaxially grow single crystal silicon, at least two chambers for ALD and CVD are required, which complicates the configuration of the apparatus. Moreover, since the oxidation is performed with ozone, there is a problem that a special generator for generating ozone is required.

Further, in the technique described in Patent Document 5, there is a problem that it is necessary to prepare two chambers with separate exhaust systems in order to prevent explosion due to reaction of SiH₄ and oxygen.

In addition, the technique described in Patent Document 6 has a problem in that a special apparatus that takes safety into consideration is required in order to prevent the oxidizing gas and the silicon film forming gas from reacting and exploding.

In the method described in Non-Patent Document 1, there is a problem that heat treatment must be performed at the time of crystallization, and the number of process steps increases. In addition, since amorphous silicon generally contains a large amount of hydrogen, defects caused by hydrogen may be formed during heat treatment for crystallization.

In addition, the conventional technology has a problem that there is no knowledge for stably introducing an oxygen layer and no specific knowledge for forming an epitaxial layer of high-quality single crystal silicon.

For example, Patent Document 2 does not describe at all a method for forming an epitaxial layer of single crystal silicon on a wafer surface without generating dislocations and stacking faults.

Moreover, Patent Documents 3 and 4 do not mention a specific method for growing a silicon wafer into which a plurality of oxygen atomic layers are introduced.

Moreover, Patent Document 7 does not describe a method for removing the native oxide film before contact with an oxidizing gas or an oxidizing solution.

As described above, while the conventional technique could obtain an atomic layer of oxygen with high accuracy, there has been problems that the structure of the apparatus is complicated, the introduction of the oxygen layer is not stable, and the epitaxial layer of high-quality single crystal silicon has not been obtained. Therefore, there is a need for an epitaxial wafer producing method that can stably and easily introduce an oxygen atomic layer into an epitaxial layer.

The present invention has been made to solve the above-described problems of the prior art, and it is an object of the present invention to provide a method for producing an epitaxial wafer which can produce an epitaxial layer of high-quality single crystal silicon and is capable of stably and easily introducing an oxygen atomic layer into an epitaxial layer.

### SOLUTION TO PROBLEM

The present invention has been made to achieve the above object, and provides a method for producing an epitaxial wafer forming a single crystal silicon layer on a single crystal silicon wafer, comprising, a step of removing native oxide film on surface of the single crystal silicon wafer with hydrofluoric acid, a step of forming an oxygen atomic layer on the surface of the single crystal silicon wafer from which the native oxide film has been removed, a step of epitaxially growing the single crystal silicon layer on the surface of the single crystal silicon wafer on which the oxygen atomic layer is formed, wherein the plane concentration of oxygen in the oxygen atomic layer is 1×10¹⁵ atoms/cm² or less.

According to such a method for producing an epitaxial wafer, single crystal silicon can be grown without forming dislocations and stacking faults on the oxygen atomic layer while leaving the oxygen atomic layer.

At this time, the method for producing an epitaxial wafer can be such that in the step of forming the oxygen atomic layer, the oxygen atomic layer is formed by rinsing the single crystal silicon wafer with pure water and/or leaving the single crystal silicon wafer in an atmosphere containing oxygen.

By rinsing with pure water in this manner, an oxygen atomic layer having a desired plane oxygen concentration can be easily formed in a short time. Alternatively, the oxygen concentration of the oxygen atomic layer can be controlled by leaving the single crystal silicon wafer in an atmosphere containing oxygen. Furthermore, by combining rinsing with pure water and leaving the wafer in an atmosphere containing oxygen, the oxygen concentration of the oxygen atomic layer can be controlled in a short period of time.

At this time, the method for producing an epitaxial wafer can be such that in the step of epitaxially growing the single crystal silicon, the epitaxial growth is performed at a temperature of 450 °C or more and 800 °C or less.

By setting the epitaxial growth temperature within such a temperature range, epitaxial growth can be performed more stably without generating defects.

At this time, the method for producing an epitaxial wafer can be such that the process of forming the oxygen atomic layer and the process of epitaxially growing the single crystal silicon can be alternately performed a plurality of times.

By providing a plurality of oxygen atomic layers in this way, it is possible to obtain an epitaxial wafer with a higher gettering effect than in the case of a single layer.

An epitaxial wafer produced by the method for producing an epitaxial wafer according to the present invention can be provided with a gettering layer in the vicinity of the device region.

### ADVANTAGEOUS EFFECTS OF INVENTION

As described above, according to the method for producing an epitaxial wafer of the present invention, it is possible to provide a method for stably introducing an oxygen atomic layer into an epitaxial layer in a silicon epitaxial wafer employed in advanced devices. In addition, it is possible to producing a proximity gettering substrate having a proximity gettering effect due to the oxygen atomic layer.

### BRIEF DESCRIPTION OF DRAWINGS

FIG. 1 is a diagram showing a flow of the epitaxial wafer producing method of the present invention;
FIG. 2 is a diagram showing an example of an epitaxial wafer obtained by the method for producing an epitaxial wafer according to the present invention;
FIG. 3 is a diagram showing another example of an epitaxial wafer obtained by the method for producing an epitaxial wafer according to the present invention;
FIG. 4 is transmission electron microscope images of cross sections of silicon epitaxial wafers in Example 1 and Comparative Example 1; and
FIG. 5 is a transmission electron microscope image of a cross section of a silicon epitaxial wafer in Example 2.

### DESCRIPTION OF EMBODIMENTS

The present invention will be described in detail below, but the present invention is not limited to these.

As described above, there is a demand for a method for producing an epitaxial wafer that does not require a special apparatus or a complicated process, stably introduces an oxygen atomic layer into the epitaxial layer, and has an epitaxial layer of high-quality single crystal silicon.

As a result of intensive studies on the above problems, inventors of the present invention have found that by a method for producing an epitaxial wafer forming a single crystal silicon layer on a single crystal silicon wafer, comprising, a step of removing native oxide film on surface of the single crystal silicon wafer with hydrofluoric acid, a step of forming an oxygen atomic layer on the surface of the single crystal silicon wafer from which the native oxide film has been removed, a step of epitaxially growing the single crystal silicon layer on the surface of the single crystal silicon wafer on which the oxygen atomic layer is formed, wherein the plane concentration of oxygen in the oxygen atomic layer is 1×10¹⁵ atoms/cm² or less, it is possible to stably and simply introduce an oxygen atomic layer without forming dislocations and stacking faults, and completed the present invention.

Description will be made below with reference to the drawings.

### [Epitaxial wafer]

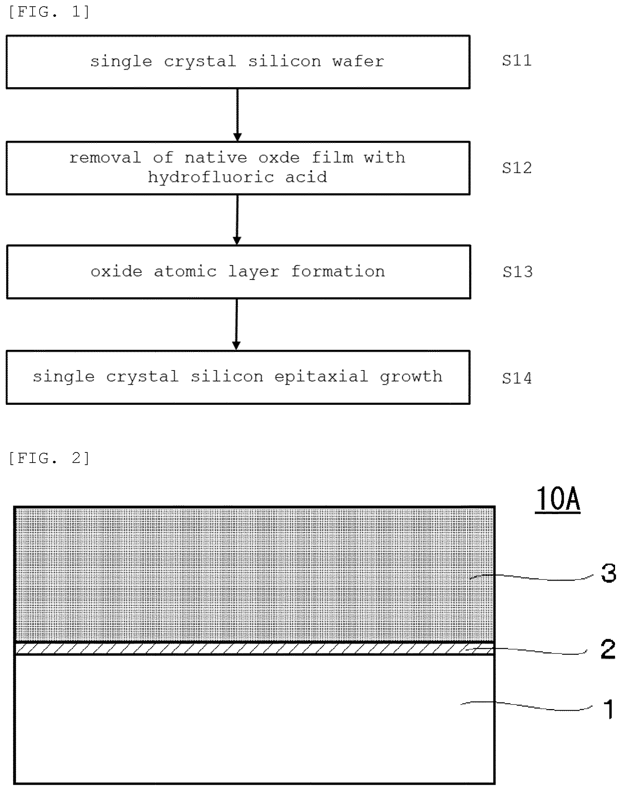

FIG. 2 is a diagram showing an example of an epitaxial wafer obtained by the method for producing an epitaxial wafer according to the present invention. An epitaxial wafer 10A according to the present invention has a single crystal silicon layer 3 on a single crystal silicon wafer 1 and an oxygen atomic layer 2 between the single crystal silicon layer 3 and the single crystal silicon wafer 1.

Here, the plane concentration of oxygen in the oxygen atomic layer 2 of the epitaxial wafer 10A according to the present invention is 1×10¹⁵ atoms/cm² or less. An epitaxial wafer having an oxygen atomic layer with a plane concentration of oxygen within such a range will have few stacking faults and dislocations in the epitaxially grown single crystal silicon layer and will have high crystallinity. Note that the lower limit of the plane concentration of oxygen is not limited, and may be greater than zero. In order to stably obtain gettering ability, it is preferably 1×10¹³ atoms/cm² or more.

Here, the single crystal silicon wafer 1 may be produced in any manner. For example, a CZ wafer produced by the Czochralski method (hereinafter referred to as the "CZ method") may be used, or an FZ wafer produced by the floating zone method (hereinafter referred to as the "FZ method") wafers may also be used. Alternatively, an epitaxial wafer obtained by epitaxially growing single crystal silicon on a single crystal silicon wafer produced by the CZ method or the FZ method may be used.

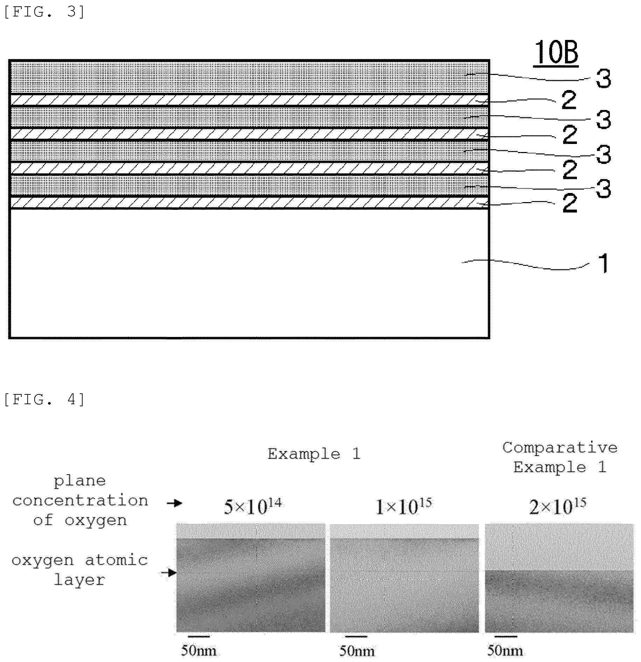

FIG. 3 is a diagram showing an epitaxial wafer 10B in which a plurality of oxygen atomic layers and single crystal silicon layers are alternately stacked on a single crystal silicon wafer. As shown in FIG. 3, an epitaxial wafer in which an oxygen atomic layer 2 and a single crystal silicon layer 3 are alternately and repeatedly laminated on a single crystal silicon wafer 1 can be obtained by the epitaxial wafer producing method of the present invention. The uppermost surface at this time is a single crystal silicon layer.

### [Method for producing an epitaxial wafer]

FIG. 1 shows the producing flow of an epitaxial wafer according to the present invention.

The step of S11 in FIG. 1 is a step of preparing a single crystal silicon wafer. Here, the producing method of the single crystal silicon wafer used as the substrate is not particularly limited. A single crystal silicon wafer produced by the CZ method or a single crystal silicon wafer produced by the FZ method may be used. Alternatively, an epitaxial wafer obtained by epitaxially growing single crystal silicon on a single crystal silicon wafer produced by the CZ method or the FZ method may be used.

The process of S12 in FIG. 1 is a process of removing the native oxide film with hydrofluoric acid (hydrofluoric acid). In the present invention, it suffices if only the native oxide film can be removed with hydrofluoric acid, and the chemical solution used may be hydrofluoric acid alone or a chemical solution containing other components such as buffered hydrofluoric acid. The concentration of hydrofluoric acid is sufficient as long as it can remove the native oxide film, and can be, for example, 0.001 % or more and 60 % or less. The temperature of hydrofluoric acid can be 10 °C or higher and 50 °C or lower. If the temperature is 10 °C or higher, the occurrence of dew condensation on the wafer after hydrofluoric acid treatment can be more effectively suppressed. Further, if the temperature is 50 °C or less, the amount of volatilized hydrofluoric acid can be set within an appropriate range, so safety can be enhanced.

The removal treatment (cleaning) of the native oxide film with hydrofluoric acid can be performed until the water repellency is confirmed, for example, 1 second or more and 1 hour or less. If the time is 1 second or more, the native oxide film can be removed more reliably. Moreover, productivity can be maintained by making it 1 hour or less.

For the hydrofluoric acid treatment (cleaning), a batch type cleaning apparatus may be used, or a single wafer type cleaning apparatus may be used.

Alternatively, the oxide film may be removed using hydrofluoric acid vapor.

The step S13 in FIG. 1 is a step of forming an oxygen atomic layer on the surface of the single crystal silicon wafer from which the native oxide film has been removed. In single crystal silicon, since oxygen atoms are stable at the bond center position between a silicon atom and the nearest silicon atom, plane concentration of oxygen is 1.36×10¹⁵ atoms/cm², when it is assumed that 1 atomic layer of oxygen is existed. If the plane concentration of oxygen is 1×10¹⁵ atoms/cm², this corresponds to 0.74 atomic layers.

A method for forming the oxygen atomic layer is not particularly limited. For example, an oxygen atomic layer can be formed by rinsing with pure water after removing the native oxide film. By using pure water, an oxygen atomic layer can be formed in a short time.

The temperature of the pure water can be 10 °C or higher and 100 °C or lower. If the temperature is 10 °C or higher, it is possible to more effectively suppress dew condensation on the wafer after rinsing with pure water. Also, the temperature can be 100 °C or lower, which is the boiling point of water.

The time for rinsing with pure water can be 1 second or more and 1 hour or less. If the time is 1 second or longer, the oxygen atomic layer can be formed more reliably. In addition, it is possible to prevent it from taking too much time by making it 1 hour or less.

Pure water rinsing may be performed using a batch type cleaning apparatus or a single wafer type cleaning apparatus.

Drying after rinsing may be performed in the air or in an inert gas atmosphere. According to studies by the inventors of the present invention, the epitaxial growth of single crystal silicon is more stable by sufficiently reducing the amount of organic matter in the atmosphere.

An oxygen atomic layer can also be formed by leaving the wafer in an atmosphere containing oxygen after removing the native oxide film.

Since an oxygen atomic layer is formed more slowly by leaving in an oxygen atmosphere than by rinsing with pure water, the oxygen concentration of the oxygen atomic layer can be accurately controlled by leaving in an oxygen-containing atmosphere. Since the surface of the silicon substrate after removing the native oxide film with hydrofluoric acid is terminated with hydrogen, it is not easily oxidized even in an oxygen atmosphere. The oxygen concentration of the oxygen atomic layer can be controlled by the leaving time and temperature. Since oxidation proceeds even at room temperature, it is not necessary to place the substrate in a heat treatment furnace for oxidation. In order to prevent defects from generating during epitaxial growth due to particles adhering to the single crystal silicon wafer, it is desirable that the environment in which the wafer is left is in a clean room.

Furthermore, in the step of forming the oxygen atomic layer, the oxygen atomic layer can be formed by a combination of rinsing with pure water and leaving the wafer in an oxygen-containing atmosphere after removing the native oxide film. By combining the formation of the oxygen atomic layer in a short time using pure water and the gentle formation of the oxygen atomic layer using oxygen, the oxygen concentration of the oxygen atomic layer can be controlled in a short period of time with high accuracy.

S14 in FIG. 1 is a step of epitaxially growing single crystal silicon. Monosilane or disilane can be used as gas used for growth. Nitrogen or hydrogen may be used as carrier gas. Moreover, the pressure of the chamber for the epitaxial growth may be any pressure that does not generate micro silicon crystals in the gas phase. For example, the pressure can be 133 Pa or more and 13300 Pa or less. As an epitaxial growth apparatus, a batch type may be used, or a single wafer type may be used.

Further, the epitaxial growth of single crystal silicon can be performed at a temperature of 450 °C or higher and 800 °C or lower. Growth at such a temperature can prevent formation of dislocations and stacking faults in the epitaxial layer. Since the higher the temperature becomes, the higher the epitaxial growth rate becomes, film formation at a high temperature makes it possible to form a thick epitaxial layer in a short time. On the other hand, if it is desired to form a thin epitaxial layer, the film should be formed at a low temperature. Thus, the growth temperature can be varied according to the desired thickness of the epitaxial layer. Also, the deposition time can be adjusted to adjust the thickness of the epitaxial layer.

When epitaxial growth of single crystal silicon is performed, hydrogen baking is usually performed immediately before the epitaxial growth for removing a native oxide film on the substrate surface and for cleaning. It is preferable to start the epitaxial growth when the predetermined growth temperature is reached without performing the hydrogen baking according to the step of epitaxial growth of the present invention. This is to prevent the disappearance of the oxygen atomic layer. The term hydrogen baking as used herein means holding a single crystal silicon wafer at 800 °C or higher in a hydrogen atmosphere for a certain period of time. Since the oxygen atomic layer does not disappear at a temperature below 800 °C, there is no problem in flowing hydrogen as a carrier gas before epitaxial growth at a temperature below 800 °C.

By setting the plane concentration of oxygen in the oxygen atomic layer to 1×10¹⁵ atoms/cm² or less, defects are not formed in the epitaxial layer. This is because the crystallinity of the substrate is maintained when the amount of oxidation is small. Therefore, there is no lower limit for the plane concentration of oxygen, and it is sufficient that it is greater than zero. When the amount of oxidation is large and the plane concentration of oxygen in the oxygen atomic layer is higher than 1×10¹⁵ atoms/cm², an epitaxial layer with high crystallinity is not formed and becomes polycrystalline silicon or amorphous silicon.

Here, the plane concentration of oxygen can be measured, for example, by SIMS (Secondary Ion Mass Spectrometry). When Si including an oxide layer is measured by SIMS, an oxygen peak is formed at the depth where the oxide layer is formed. The plane concentration can be obtained by accumulating the product of the volume concentration and the depth due to one sputtering in the vicinity of the peak.

The step of forming an oxygen atomic layer on the surface of the single crystal silicon wafer and the step of epitaxially growing single crystal silicon can be alternately performed multiple times. By providing a plurality of oxygen atomic layers in this manner, the gettering effect can be enhanced as compared with the case of a single layer.

### EXAMPLE

The present invention will be described in detail below with reference to examples, but these are not intended to limit the present invention.

### (Example 1, Comparative Example 1)

The conductivity type, diameter, and crystal plane orientation of the prepared single crystal silicon substrate are as follows.

| | |
|---|---|
| Substrate conductivity type : | p-type |
| Diameter : | 300mm |
| Crystal plane orientation : | (100) |

Next, in order to remove the native oxide film of the prepared single crystal silicon substrate, the substrate was cleaned with hydrofluoric acid in a batch type apparatus and then rinsed with pure water. After that, it was left in the atmosphere of cleanliness class 100 for 2 to 5 hours. Specifically, the leaving time was 2 hours and 3 hours in Example 1, and 5 hours in Comparative Example 1. Next, single crystal silicon was epitaxially grown without hydrogen baking. At this time, the pressure was 4000 Pa and the growth temperature was 580 °C.

After that, the plane concentration of oxygen in the oxygen atomic layer was measured by SIMS. In addition, cross-sectional TEM (Transmission Electron Microscopy) observation was performed to evaluate the crystallinity. The observation results are shown in FIG. 4.

As a result of SIMS measurement, it was found that, in Example 1, plane oxygen concentrations of 5×10¹⁴ atoms/cm² and 1×10¹⁵ atoms/cm² were obtained, and in Comparative Example 1, plane oxygen concentration of 2×10¹⁵ atoms/cm² was obtained.

From the results of cross-sectional TEM observation (FIG. 4), when the plane concentration of oxygen is 1×10¹⁵ atoms/cm² or less as in Example 1, it can be seen that a single crystal silicon layer was formed on the oxygen atomic layer without formation of dislocations and stacking faults. On the other hand, when the plane concentration of oxygen is 2×10¹⁵ atoms/cm² as in Comparative Example 1, the epitaxial layer has not been single crystal silicon but amorphous silicon. Note that in the cross-sectional TEM observation image of Comparative Example 1 in FIG. 4, the entire upper half of the image is the amorphous silicon layer. In this case, amorphous silicon becomes polysilicon when heat treatment is performed after film formation.

### (Example 2)

The same single crystal silicon substrates as in Example 1 and Comparative Example 1 were prepared. Next, in order to remove a native oxide film from the prepared single crystal silicon substrate, the substrate was cleaned with hydrofluoric acid using a batch type or single wafer type apparatus, and then rinsed with pure water. After that, an oxygen atomic layer was formed so that the exposure time in the atmosphere of cleanliness class 100 was within 10 minutes, and then epitaxial growth of single crystal silicon was performed without hydrogen baking. At this time, the pressure was 4000 Pa and the growth temperature was 580 °C.

After that, the plane concentration of oxygen in the oxygen atomic layer was measured by SIMS. As a result, the plane concentration of oxygen in the oxygen atomic layer was 1×10¹⁴ atoms/cm² in both hydrofluoric acid cleaning methods.

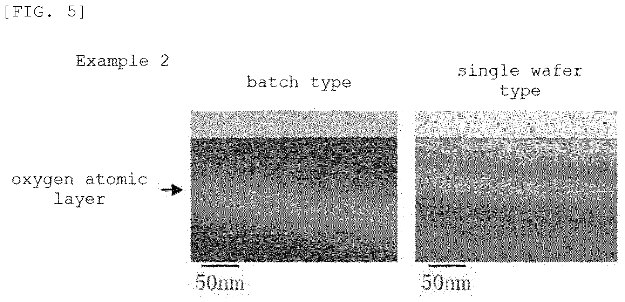

Furthermore, cross-sectional TEM observation was performed to evaluate the crystallinity. The observation results are shown in FIG. 5. It can be seen that a single crystal silicon layer was formed on the oxygen atomic layer without formation of dislocations and stacking faults. When the plane concentration of oxygen in the oxygen atomic layer is about 1×10¹⁴ atoms/cm² as in Example 2, the change in the contrast of the oxygen atomic layer in the cross-sectional TEM observation image becomes weak. Although the oxygen atomic layer is difficult to see compared with the cross-sectional TEM observation image of Example 1 in FIG. 4, SIMS measurement shows a clear oxygen peak in the oxygen atomic layer portion, confirming the existence of the oxygen atomic layer.

With the method for producing an epitaxial wafer according to the present invention, it becomes possible that an oxygen atomic layer can be stably and easily introduced into the epitaxial layer, and an epitaxial wafer having an epitaxial layer of high-quality single crystal silicon can be obtained.

The present invention is not limited to the above embodiments. The above-described embodiments are just examples, and any examples that substantially have the same configuration and demonstrate the same functions and effects as those in the technical concept disclosed in the claims of the present invention are included in the technical scope of the present invention.

## Claims

1. A method for producing an epitaxial wafer forming a single crystal silicon layer on a single crystal silicon wafer, comprising,
a step of removing native oxide film on surface of the single crystal silicon wafer with hydrofluoric acid,
a step of forming an oxygen atomic layer on the surface of the single crystal silicon wafer from which the native oxide film has been removed,
a step of epitaxially growing the single crystal silicon layer on the surface of the single crystal silicon wafer on which the oxygen atomic layer is formed,
wherein the plane concentration of oxygen in the oxygen atomic layer is 1×10¹⁵ atoms/cm² or less.

2. The method for producing an epitaxial wafer according to claim 1, wherein,
in the step of forming the oxygen atomic layer, the oxygen atomic layer is formed by rinsing the single crystal silicon wafer with pure water and/or leaving the single crystal silicon wafer in an atmosphere containing oxygen.

3. The method for producing an epitaxial wafer according to claim 1 or claim 2, wherein,
in the step of epitaxially growing the single crystal silicon, the epitaxial growth is performed at a temperature of 450 °C or more and 800 °C or less.

4. The method for producing an epitaxial wafer according to any one of claims 1 to 3, wherein the step of forming the oxygen atomic layer and the step of epitaxially growing the single crystal silicon are alternately performed a plurality of times.
